# EUROPEAN PATENT APPLICATION

(11) **EP 4 173 725 A1**
(43) Date of publication of application: **03.05.2023**
(21) Application number: 20942288.0
(22) Date of filing: 26.06.2020
(51) Int. Cl.: B05C 11/08, B05D 1/40, G03F 7/16, H01L 21/027

(54) **SPIN-COATING DEVICE**

(71) Applicant: Mikasa Co., Ltd., Tokyo 105-0011 (JP)
(72) Inventor: YAMADA Tomoshige, Tokyo 105-0011 (JP)
(74) Representative: Becker, Eberhard
(86) International application number: PCT/JP2020/025336
(87) International publication number: WO 2021/260943

(57) **Abstract**

[Problem] To provide a spin-coating device having a film thickness measurement unit (1) and an operation adjustment unit (2). [Solution] In the present invention, a film thickness measurement unit (1) measures, by interferometry, the real-time film thickness of a film formed from a coating solution. The operation adjustment unit (2) adjusts operation of the spin-coating device in accordance with the real-time thickness of the film formed from a coating solution.

## Description

### Technical Field

The present invention relates to a spin-coating device, a spin-coating method using the same, and a method of selecting optimum spin-coating conditions.

### Background Art

A spin-coating device is one of typical apparatuses used to apply a resist material to a semiconductor substrate such as a silicon wafer or a mask substrate. In the case of such a spin-coating device, a substrate is fixed on a rotary table and a resist material is dripped onto a central portion of the substrate. Next, the rotary table on which the substrate is fixed is rotated at high speed to generate a centrifugal force, so that a photoresist is spread to an end portion from the center of a semiconductor substrate and a resist layer is formed on a substrate surface.

In the case of spin-coating, it is necessary to control the thickness of a film layer on a substrate to reach a target value. Therefore, there are various control methods proposed. For example, described in PTL 1 is controlling a variation in film thickness caused by a substrate processing temperature by adjusting the rotation rate of a substrate in relation to the measured temperature of the substrate. Described in PTL 2 is uniformly applying a resist material to a surface of a wafer, of which an end portion has a sharp shape, by combining different rotation steps with each other. Described in PTL 3 is suppressing a variation in film thickness by coating a substrate surface with coating liquid, holding the substrate surface without rotation for a certain period of time, and then performing spin-coating by means of rotation thereafter. In addition, described in PTL 4, PTL 5, and PTL 6 is improving the structure of a rotary table or a component attached thereto in order to form a more uniform coating film.

### Citation List

### Patent Literature

[PTL 1] JP-A-2010-40921
[PTL 2] JP-A-2012-256780
[PTL 3] JP-A-2006-231262
[PTL 4] JP-A-2018-202318
[PTL 5] JP-A-2016-73240
[PTL 6] JP-A-2014-22452
As shown in these examples, in film thickness control in the related art, the final film thickness is made closer to an ideal state by adjusting operating conditions such as the rotation rate of a spin-coating device or the structure thereof. In these methods, a coating test is performed under certain operating conditions or with a certain structure, the obtained coating film is analyzed, and the result of analysis is compared with a target quality to determine whether or not the operating conditions or the structure has a problem. In a case where it is determined that the operating conditions or the structure needs to be adjusted, the operating conditions or the structure is based on deviation between the result of the test and a target value. Then, the coating test is performed again under the reset operating conditions or with the reset structure, and the same analysis and determination are performed.

In such a method, the thickness of the coating film during or after formation is not directly detected during operation of the spin-coating device. Therefore, the operating conditions or the structure of the spin-coating device at the time of the test cannot be evaluated until the results of analysis of the coating film obtained in the test are accumulated and evaluated. Accordingly, in the case of a method in the related art, a large number of trials and errors are needed to be made until figuring out the ideal operating conditions or the ideal structure of the spin-coating device (so-called optimal condition establishment). Particularly, in the case of products such as a resist substrate, which has a relatively short life cycle and require mass production, time and cost required for such "optimal condition establishment" are not favorable in the market competition.

Therefore, the present inventor has examined means for shortening a period of time required for the above-described optimal condition establishment in manufacture of a resist substrate in which a spin-coating device is used. As a result, the present inventor has succeeded in directly and quickly evaluating the operating conditions of a spin-coating device during operation by directly measuring the thickness of a film formed of coating liquid during operation of the spin-coating device. That is, the present invention is as follows.

(Invention 1) A spin-coating device including a film thickness measurement unit (1), and an operation adjustment unit (2), in which the film thickness measurement unit (1) measures a real-time thickness of a film formed of coating liquid by means of interferometry, and the operation adjustment unit (2) adjusts operation of the spin-coating device in accordance with the real-time thickness of the film formed of the coating liquid.

(Invention 2) The spin-coating device according to Invention 1, in which the film thickness measurement unit (1) includes a light source (101), an irradiation unit (102), a light receiving unit (103), a spectroscopic unit (104), and a film thickness calculation unit (105), and the operation adjustment unit (2) includes a memory (201) and a control unit (202).

(Invention 3) The spin-coating device according to Invention 1, in which the film thickness measurement unit (1) measures a real-time thickness of a film formed of a resist material by means of optical interferometry, the operation adjustment unit (2) stops rotation of the spin-coating device when the real-time thickness of the film formed of the resist material reaches a predetermined range, and the spin-coating device is for applying the resist material onto a substrate.

(Invention 4) A spin-coating method which uses the spin-coating device according to Invention 1.

(Invention 5) A method of selecting optimum spin-coating conditions which uses the spin-coating device according to Invention 1.

### Summary of Invention

[Spin-Coating Device] A "spin-coating device" described in the present specification is a device also called a spin coater or a spinner. The spin-coating device of the present invention includes a film thickness measurement unit (1) and an operation adjustment unit (2) which will be described later and has all other functions and portions required for a general spin-coating device. That is, a main body of the spin-coating device of the present invention includes a rotary table for installation of a coating target, a nozzle that drips coating liquid onto the coating target, a rotation mechanism and a circuit for rotation of the rotary table, and a control unit of the rotation mechanism. The spin-coating device of the present invention can include an outer cylinder, enclosing means such as a lid or lock means, a display unit, and an input unit such as a touch panel or a button, which are attached to the main body. The specifications and operating conditions of the main body and attachments thereof are appropriately designed in accordance with the material and shape (the thickness and the diameter) of the coating target and the characteristics of the coating liquid. The coating liquid applied to the spin-coating device of the present invention is not limited as long as the coating liquid has appropriate fluidity that enables spin-coating and the thickness of a film formed of the coating liquid can be measured by means of interferometry during the spin-coating. Such coating liquid is, for example, various reactive or non-reactive coating materials or lamination materials and is typically a photosensitive material such as a resist material.

[Film Thickness Measurement Unit (1)] The spin-coating device of the present invention includes the film thickness measurement unit (1). The film thickness measurement unit (1) can measure the thickness of a film that is formed of coating liquid and that is formed on a surface of a coating target by means of interferometry regardless of the state of operation of the spin-coating device of the present invention (regardless of whether or not the spin-coating device is being rotated).

The film thickness measurement unit (1) irradiates the surface of the coating target with light from an irradiation unit (102) that is generated by a light source (101), and a light receiving unit (103) detects interference light from the surface. Generally, an LED is used as the light source (101), and white light is emitted from the irradiation unit (102). In a case where a measurement target is a resist material (resist liquid), control is performed such that the wavelength of light emitted from the irradiation unit (102) does not fall into the photosensitive wavelength range of the resist material. In this case, the wavelength of the light emitted from the irradiation unit (102) is controlled to be equal to or greater than 400 nm, preferably equal to or greater than 430 nm and equal to or smaller than 700 nm, and more preferably equal to or greater than 440 nm and equal to or smaller than 700 nm. The positional relationship between the irradiation unit (102), the light receiving unit (103), and the rotary table (a distance from a reference point such as the central portion of a substrate, a peripheral portion of the substrate, or the surface of the film formed of the coating liquid) is not limited as long as the accuracy of measurement can be secured.

The detected interference light is sent to a spectroscopic unit (104) so that the spectroscopic intensity of the interference light is measured. The measured value of the spectroscopic intensity is sent to a film thickness calculation unit (105). The film thickness calculation unit (105) uses a calculation program, in which a function defined by parameters such as light irradiation conditions (λ: wavelength, Φ: angle of incidence) and optical constants of the coating liquid (n: refractive index, k: extinction coefficient) is used, to output the real-time thickness of the film formed of the coating liquid. Here, comparison between an actual measurement value and a theoretical value is performed, and a value obtained through correction of the actual measurement value is output as the real-time thickness of the film formed of the coating liquid present on the coating target at the time of irradiation with the light. The calculation program and a correction method can be adopted from a variety of conventional methods without any limitation.

By continuously irradiating the surface of the coating target with the light from the irradiation unit (102), the film thickness measurement unit (1) can measure the thickness of the film formed of the coating liquid that changes moment by moment during the operation of the spin-coating device. The film thickness measurement unit (1) can output, in conjunction with the operation adjustment unit (2) which will be described later, data about a change with time in film thickness from the measured value obtained by the film thickness measurement unit (1). In this case, the film thickness measurement unit (1) and the operation adjustment unit (2) also function as a device monitoring the thickness of the film formed of the coating liquid. An interval between times of measurement can be freely set in accordance with desired accuracy and desired application time. Generally, the number of measured values output by the film thickness calculation unit (105) per second is set to 1 or more and 20 or less, preferably 2 or more and 10 or less.

[Operation Adjustment Unit (2)] The spin-coating device of the present invention includes the operation adjustment unit (2). The operation adjustment unit (2) is directly incorporated in the control unit provided in the main body of the spin-coating device of the present invention, or is communicably connected to the control unit provided in the main body of the spin-coating device. The operation adjustment unit (2) receives the real-time thickness of the film formed of the coating liquid which is output by the film thickness measurement unit (1) and stores the real-time thickness in a memory (201). A control unit (202) of the film thickness measurement unit (1) compares the real-time thickness of the film formed of the coating liquid that is stored in the memory (201) with a film thickness value (a prescribed thickness) set in advance and determines whether or not the real-time thickness of the film formed of the coating liquid has reached the prescribed thickness. In a case where the control unit (202) determines that the real-time thickness of the film formed of the coating liquid has reached the prescribed thickness, the control unit (202) generates an operation change command for the spin-coating device of the present invention, and the operation change command is transmitted to the control unit provided in the main body of the spin-coating device of the present invention.

The prescribed thickness is appropriately set in accordance with the target value/ideal value of the thickness of the film formed of the coating liquid. For example, in a case where the prescribed thickness coincides with or is brought close to the target value/ideal value of the thickness of the film formed of the coating liquid, the operation adjustment unit (2) transmits an operation stoppage command or an operation stoppage preparation command to the control unit provided in the main body of the spin-coating device of the present invention. Then, the rotation of the rotary table of the spin-coating device of the present invention is stopped or a transition to a stoppage preparation mode is performed.

[Display Unit (3)] The spin-coating device of the present invention can include a display unit (3) for displaying the thickness or the like of the film formed of the coating liquid that is generated by the film thickness measurement unit (1), the display unit (3) being the same as or different from the display unit attached to the main body of the spin-coating device of the present invention. A user of the spin-coating device of the present invention can observe or monitor operation of the spin-coating device of the present invention by means of the real-time thickness of the film formed of the coating liquid that is displayed on the display unit (3), a change with time of the film formed of the coating liquid, past coating data, the state of operation of the rotary table, or the like.

The user can input, the input unit attached to the main body of the spin-coating device of the present invention or an input unit different from the above-described input unit, the operation change command for the spin-coating device of the present invention in response to contents displayed on the display unit (3).

[Communication Means (4)] The spin-coating device of the present invention can be provided with communication means (4) for connection between the main body, the attachments thereof, the film thickness measurement unit (1), the operation adjustment unit (2), and the display unit (3). The communication means (4) is not particularly limited as long as the communication means (4) is adaptive to a device to be connected. Generally, a cable, a wireless LAN, Bluetooth (registered trademark), infrared communication, near field communication (NFC), and the like which are short-range communication means are suitable. In addition, it is also possible to issue an operation instruction or perform observation via an external terminal with the spin-coating device of the present invention connected to the Internet.

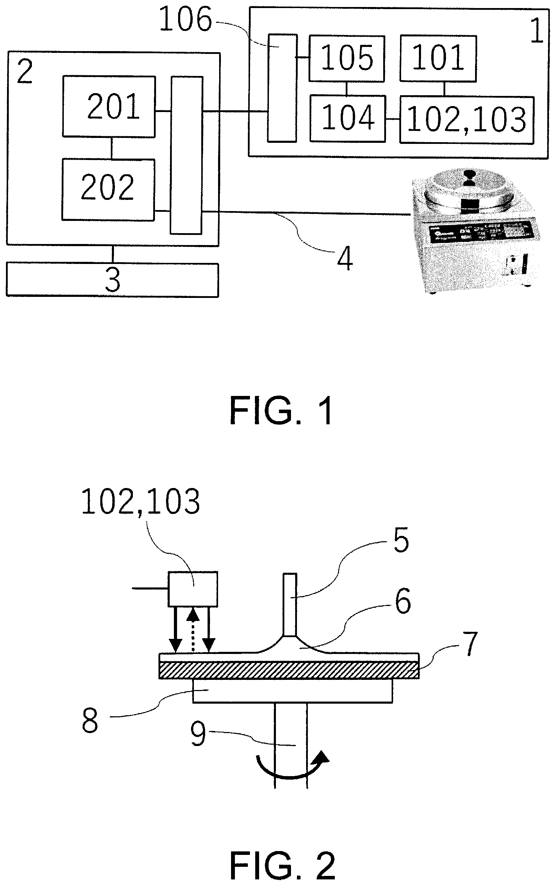

FIG. 1 shows a relationship of each part in the spin-coating device of the present invention. FIG. 2 schematically shows the way in which irradiation with light and detection of light are performed by the irradiation unit (102) and the light receiving unit (103) of the spin-coating device of the present invention. In FIGS. 1 and 2, some of actual circuits, connection means, and components are not shown. FIGS. 1 and 2 are reference diagrams for understanding an example of disposition of each part and do not show the actual size and shape of the device. The present invention is not limited to states as shown in FIGS. 1 and 2.

[Spin-coating method] In a spin-coating method of the present invention, the above-described spin-coating device is used. With the spin-coating method of the present invention, it is possible to acquire the real-time thickness of a film formed of coating liquid in parallel with spin-coating and to perform operation control of the spin-coating device based on the acquired thickness during the spin-coating.

[Method of Selecting Optimum Spin-Coating Conditions] With such a spin-coating device of the present invention, it is possible to simultaneously perform production and invention of a substrate with a coating film in parallel with each other and to adjust and control spin-coating conditions in accordance with values measured in real time for each product. In addition, with the spin-coating device of the present invention, it is possible to detect a change with time in coating liquid film thickness and thus it is possible to accurately and simply cause the time of rotation of a rotary table or the rotation rate of the rotary table to fit a target/ideal value.

Therefore, the spin-coating device of the present invention is particularly effective in selecting optimum spin-coating conditions in test production or pilot production.

### Brief Description of Drawings

FIG. 1 schematically shows a spin-coating device of the present invention.
FIG. 2 schematically shows the way in which irradiation with light and detection of light are performed by the spin-coating device of the present invention.
FIG. 3 schematically shows an example of the spin-coating device of the present invention.
FIG. 4 is a graph that shows a change with time in real-time thickness of a resist material in Example 1.

### Description of Embodiments

### [Example 1]

A film formed of a resist material was formed on a substrate by means of a spin-coating device of the present invention.

### (Spin-Coating)

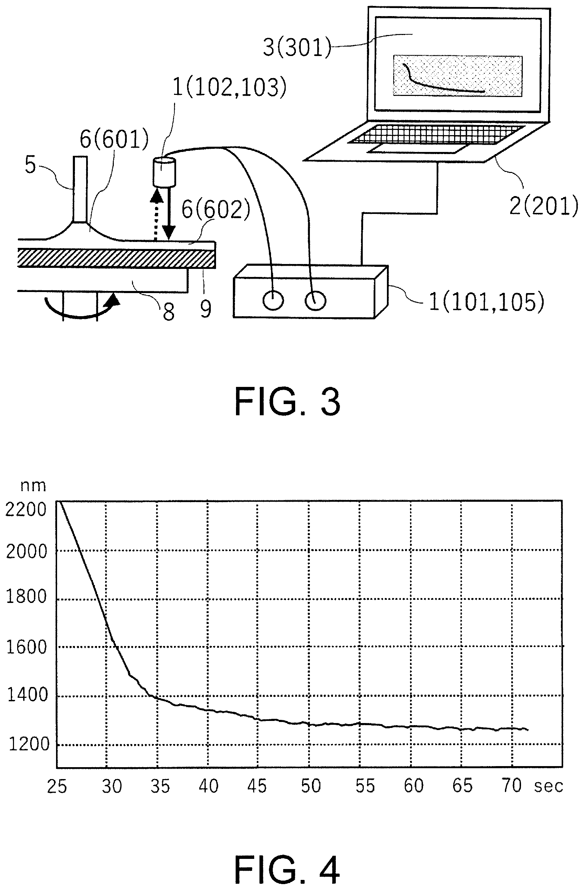

By means of the spin-coating device of the present invention, spin-coating was performed while measuring the film thickness of the resist material. FIG. 3 shows the spin-coating device used here. A nozzle (5) drips 6 ml of a resist material (6) onto a central portion of a substrate. The dripped resist material (601) is spread to reach an end portion of the substrate because of a centrifugal force caused by rotation of a rotary table (8) (rotation speed: 3200 rpm), so that a film (602) is formed. A film thickness measurement unit (1) irradiates the film (602) formed of the resist material (6) with light having a wavelength equal to or larger than 400 nm and equal to or smaller than 700 nm three times per second at regular intervals. The film thickness measurement unit (1) calculates the real-time thickness of the resist material (6) on the substrate from the thickness of the film (602) at a point irradiated with the light. Note that FIG. 3 is a schematic diagram for helping understanding of this example, and does not precisely reproduce the shape or disposition of the actual device. For example, the rotary table, a portion of a material on the rotary table, a member to which the nozzle is connected, a portion of communication connection means, a power source, and the like are not shown.

The real-time thickness of the resist material (6) on the substrate which is output from the film thickness measurement unit (1) is stored in a memory (201) of a PC (2) functioning as an operation adjustment unit (2) together with other data related to coating. The PC (2) converts stored data into display data by means of a predetermined program.

In the operation adjustment unit (2), a desired thickness of the resist material (6) on the substrate is prescribed as target values. In a case where the real-time thickness of the resist material (6) on the substrate that is received from the film thickness measurement unit (1) matches the target values, the operation adjustment unit (2) transmits a rotary table stoppage command to the spin-coating device. In the present example, as the target values, a minimum value was set to 1100 nm and a maximum value was set to 1250 nm so that the resist material forms a film having a thickness of 1000 nm on the substrate in the end after baking. A control unit of the PC (2) compared the real-time thickness of the resist material (6) generated on the substrate with the target values (the minimum value and the maximum value) and stopped the rotary table (8) when the real-time thickness of the resist material (6) generated on the substrate reached a target range (a range of 1100 nm to 1250 nm).

A screen (301) of the PC which functions as a display unit (3) displays a change with time in real-time thickness of the resist material (6) on the substrate in accordance with the display data output from the PC (2). In the present example, a graph shown in FIG. 4 was displayed on the screen (301) for purpose of observing a change with time in real-time thickness of the resist material (6). The vertical axis of the graph in FIG. 4 represents the thickness (nm) and the horizontal axis represents time (seconds).

Rotation of the rotary table (8) was started 30 seconds after the start of measurement of time. After the start of the rotation, the real-time thickness of the resist material (6) on the substrate was rapidly decreased in about 10 seconds and reached the target range (a range of 1100 nm to 1250 nm) 70 seconds after the start of the measurement of time. Therefore, the PC (2) transmitted a rotation stoppage command to a main body of the spin-coating device. As a result, the operation of the rotary table (8) was stopped and the spin-coating ended. Throughout a time from the start to the end of the spin-coating, the temperature of a spin-coating atmosphere (the inside of a chamber where the rotary table of the spin-coating device was placed) and the temperature of a discharge portion of the nozzle were constant at 23°C.

### (Drying and Baking)

The obtained substrate was dried and heated to obtain a substrate (a substrate A1) coated with the film formed of the resist material.

### (Film Thickness Measurement)

At a plurality of points on the substrate A1, the thickness of the film formed of the resist material was measured by means of interferometry.

### [Example 2]

Spin-coating, drying, and heating were performed on a new substrate in the same manner as the substrate A1 to obtain a substrate A2. In the case of the spin-coating of the substrate A2, operation of the rotary table (8) was stopped after 72 seconds from the start of measurement of time. Although there was a period, in which the temperature of the spin-coating atmosphere (the inside of the chamber where the rotary table of the spin-coating device was placed) or the temperature of the discharge portion of the nozzle changed from 23°C, within a time from the start to the end of the spin-coating of the substrate A2, there was no change in conditions set for the film thickness measurement unit (1) and the PC (2). At a plurality of points on the substrate A2, the thickness of the film formed of the resist material was measured by means of interferometry.

### [Example 3]

Furthermore, spin-coating, drying, and heating were performed on a new substrate in the same manner as the substrate A1 to obtain a substrate A3. In the case of the spin-coating of the substrate A3, operation of the rotary table (8) was stopped after 79 seconds from the start of measurement of time. Although there was a period, in which the temperature of the spin-coating atmosphere (the inside of the chamber where the rotary table of the spin-coating device was placed) or the temperature of the discharge portion of the nozzle changed from 23°C, within a time from the start to the end of the spin-coating of the substrate A3, there was no change in conditions set for the film thickness measurement unit (1) and the PC (2). At a plurality of points on the substrate A3, the thickness of the film formed of the resist material was measured by means of interferometry.

### [Reference Examples 1, 2, and 3]

Separately, optimum operating conditions for a spin-coating device main body were determined by means of a method in the related art such that the film formed of the resist material has a thickness of 1000 nm in the end. The above-described optimum operating conditions were determined in consideration of the temperature of the spin-coating atmosphere. Spin-coating was performed under the determined optimum operating conditions. The obtained substrate was dried and heated under the same conditions as Examples 1, 2, and 3 to obtain three substrates (substrates B1, B2, and B3) each of which was coated with a film formed of a resist material.

For each of the substrates B1, B2, and B3 as well, the thickness of the film formed of the resist material was measured by means of interferometry under the same conditions as Examples 1, 2, and 3.

### [Evaluation]

No significant difference in average film thickness and degree of variation in film thickness was observed between the substrates A1, A2, and A3 and the substrates B1, B2, and B3. From this, it can be found that film thickness measurement performed during spin-coating in Examples did not damage formation of a coating liquid (resist material) film.

In the spin-coating of Examples 1, 2, and 3, a rotary table stoppage command of the PC (2) was generated without being affected by a change in temperature of the spin-coating atmosphere, and the length of spin-coating time was adjusted to an optimum length by means of the stoppage command. However, in the spin-coating of Reference Examples 1, 2, and 3, it was necessary to determine in advance the optimum operating conditions for the spin-coating device main body in consideration of the temperature of the spin-coating atmosphere. Therefore, so-called optimal condition establishment was complicated in comparison with the case of Examples.

### Industrial Applicability

The spin-coating device of the present invention, a spin-coating method using the same, and a method of selecting optimum spin-coating conditions simplify a step of manufacturing various products manufactured with spin-coating. The present invention particularly contributes to reduction of the manufacturing cost and improvement of the quality of a precision-processed product such as a resist substrate.

### Reference Signs List

1: film thickness measurement unit
101: light source
102: irradiation unit
103: light receiving unit
104: spectroscopic unit
105: film thickness calculation unit
106: communication unit
2: operation adjustment unit
201: memory
202: control unit
203: communication unit
3: display unit
301: screen
4: communication means (cable)
5: nozzle
6: coating liquid
601: dripped resist material
602: film formed of the resist material
7: substrate
8: rotary table
9: rotation mechanism

## Claims

1. A spin-coating device comprising:
a film thickness measurement unit (1); and
an operation adjustment unit (2),
wherein the film thickness measurement unit (1) measures a real-time thickness of a film formed of coating liquid by means of interferometry, and
the operation adjustment unit (2) adjusts operation of the spin-coating device in accordance with the real-time thickness of the film formed of the coating liquid.

2. The spin-coating device according to Claim 1,
wherein the film thickness measurement unit (1) includes a light source (101), an irradiation unit (102), a light receiving unit (103), a spectroscopic unit (104), and a film thickness calculation unit (105), and
the operation adjustment unit (2) includes a memory (201) and a control unit (202).

3. The spin-coating device according to Claim 1,
wherein the film thickness measurement unit (1) measures a real-time thickness of a film formed of a resist material by means of optical interferometry,
the operation adjustment unit (2) stops rotation of the spin-coating device when the real-time thickness of the film formed of the resist material reaches a predetermined range, and
the spin-coating device is for applying the resist material onto a substrate.

4. A spin-coating method which uses the spin-coating device according to Claim 1.

5. A method of selecting optimum spin-coating conditions which uses the spin-coating device according to Claim 1.
